# FASCICULE DE BREVET EUROPEEN

(11) **EP 2 895 285 B1**
(45) Date de publication et mention de la délivrance du brevet: **14.08.2019**
(21) Numéro de dépôt: 13765382.0
(22) Date de dépôt: 06.09.2013
(51) Int. Cl.: B22D 27/04, B22C 7/02, B22C 9/04, C30B 11/00

(54) **MODELE DE FONDERIE.**
GUSSKÖRPERMODELL
FOUNDRY MODEL

(30) Priorité: 11.09.2012 FR 1258526
(43) Date de publication de la demande: 22.07.2015
(73) Titulaire: Safran Aircraft Engines, 75015 Paris (FR)
(72) Inventeur: COYEZ, Dominique, F-77550 Moissy-cramayel Cedex (FR); FARGEAS, Serge, F-77550 Moissy-cramayel Cedex (FR)
(74) Mandataire: Calvo de Nó, Rodrigo
(86) Numéro de dépôt international: PCT/FR2013/052064
(87) Numéro de publication internationale: WO 2014/041288

(56) Documents cités:
- DE-A1- 10 033 688
- US-A- 3 411 563

## Description

### Arrière-plan de l'invention

La présente invention concerne le domaine de la fonderie, et plus particulièrement un modèle pour fonderie à modèle perdu, ainsi que des procédés de fabrication de moules carapaces et de fonderie utilisant un tel modèle.

Des procédés de fonderie dits à cire perdue ou à modèle perdu sont connus depuis l'antiquité. Ils sont particulièrement adaptés pour la production de pièces métalliques avec des formes complexes. Ainsi, la fonderie à modèle perdu est notamment utilisée pour la production de pales de turbomachines.

Dans la fonderie à modèle perdu, la première étape est normalement la réalisation d'un modèle en matériau à température de fusion comparativement peu élevée, comme par exemple une cire ou résine, sur laquelle est ensuite surmoulé un moule. Après évacuation du matériau du modèle de l'intérieur du moule, ce qui donne son nom à ces procédés, un métal en fusion est coulé dans ce moule, afin de remplir la cavité formée par le modèle dans le moule après son évacuation. Une fois que le métal se refroidit et solidifie, le moule peut être ouvert ou détruit afin de récupérer une pièce métallique conforme à la forme du modèle. On entend par « métal », dans le présent contexte, tant des métaux purs que, surtout, des alliages métalliques.

Afin de pouvoir produire plusieurs pièces simultanément, il est possible de réunir plusieurs modèles dans une seule grappe dans laquelle ils sont reliés par un arbre formant, dans le moule, des canaux de coulée pour le métal en fusion.

Parmi les différents types de moules pouvant être utilisés dans la fonderie à modèle perdu, on connaît notamment les moules dits moules carapace, formés par trempage du modèle ou de la grappe de modèles dans une barbotine, suivi d'un saupoudrage du modèle ou de la grappe enduits de barbotine avec du sable réfractaire pour former une carapace autour du modèle ou de la grappe, et de la cuisson de cette carapace pour solidifier la barbotine de manière à consolider l'ensemble. Plusieurs trempages et saupoudrages successifs peuvent être envisagés afin d'obtenir une carapace d'une épaisseur suffisante avant sa cuisson. On entend par « sable réfractaire », dans le présent contexte, tout matériau granulaire avec une granularité suffisamment fine pour satisfaire aux tolérances de production souhaitées, capable de résister, à l'état solide, les températures du métal en fusion, et pouvant être consolidé en une seule pièce solide par la barbotine lors de la cuisson de la carapace.

Afin d'obtenir des propriétés thermomécaniques particulièrement avantageuses dans une pièce produite par fonderie, il peut être souhaitable d'assurer une solidification dirigée du métal dans le moule. On entend par « solidification dirigée », dans le présent contexte, comme la maîtrise de la germination et croissance de cristaux solides dans le métal en fusion lors de son passage de l'état liquide à l'état solide. L'objet d'une telle solidification dirigée est celui d'éviter les effets négatifs des joints de grains dans la pièce. Ainsi, la solidification dirigée peut être colonnaire ou monocristalline. La solidification dirigée colonnaire consiste à orienter tous les joints de grains dans une même direction, de manière à ce qu'ils ne puissent pas contribuer à la propagation de fissures. La solidification dirigée monocristalline consiste à assurer la solidification de la pièce en un seul cristal, de manière à supprimer totalement les joints de grains.

La solidification dirigée est particulièrement souhaitable dans la production de pièces destinées à subir de grandes contraintes thermomécaniques, comme les pales de turbomachines. Toutefois, les formes complexes de ces pales peuvent interférer avec la solidification dirigée, générant des grains parasites notamment à proximité d'angles vifs de la pale. En particulier, dans une pale de turbomachine avec un pied et un corps séparés par une plateforme sensiblement perpendiculaire à un axe principal de la pale, ledit corps présentant un intrados, un extrados, un bord d'attaque et un bord de fuite, la transition brusque entre le corps de la pale et la plateforme peut générer la formation de tels grains parasites, notamment au niveau du bord de fuite.

Afin de réduire la masse des pales de turbomachine, mais surtout de permettre leur refroidissement, il est courant de noyer des noyaux réfractaires dans le modèle non-permanent. Un tel noyau réfractaire reste dans le moule carapace après l'évacuation du matériau du modèle, la coulée et le refroidissement du métal, formant ainsi un volume creux dans la pièce métallique. En particulier, pour assurer un bon refroidissement du bord de fuite, dont l'épaisseur réduite le rend particulièrement vulnérable aux hautes températures, il est courant qu'un tel noyau affleure à la surface du modèle au bord de fuite, de manière à former une fente de refroidissement du bord de fuite. Toutefois, la faible épaisseur du noyau à cet endroit le rend fragile. En outre, afin de maintenir le positionnement correct du noyau dans le moule carapace pendant la coulée et le refroidissement du métal, il est souhaitable d'assurer le guidage de sa dilatation thermique. Pour cela, le modèle peut comprendre une barrette de guidage adjacente au bord de fuite, avec une surface vernie du noyau réfractaire affleurant de chaque côté du modèle entre le bord de fuite et la barrette de dilatation. Le vernis sur ces surfaces, qui peut être évacué du moule carapace avec le matériau du modèle, assure un faible jeu (de l'ordre de quelques centièmes de millimètre) entre le noyau réfractaire et le moule carapace, de manière à guider la dilatation du noyau à cet endroit perpendiculairement à son épaisseur. A l'intérieur de la barrette de dilatation, le noyau peut avoir une plus grande épaisseur, ce qui accroît sa robustesse.

Toutefois, la complexité de la géométrie de la cavité du moule au niveau des intersections du bord de fuite et de la barrette de dilatation avec la plateforme de la pale accroît sensiblement le risque de génération de grains

### Objet et résumé de l'invention

La présente invention vise à remédier à ces inconvénients. Notamment, l'invention vise à proposer un modèle qui permette d'éviter la formation de grains parasites à proximité des intersections du bord de fuite et de la barrette de dilatation avec la plateforme d'une pale de turbomachine produite à partir de ce modèle dans un procédé de fonderie à modèle perdu.

Dans au moins un mode de réalisation de la présente invention, ce but est atteint grâce au fait que le modèle comprend aussi un voile s'étendant entre la plateforme et ladite barrette de dilatation et présentant un bord libre entre les deux. On entend par « voile », dans le présent contexte, une paroi très fine, dont l'épaisseur est donc sensiblement inférieure aux autres dimensions. L'épaisseur du voile n'est toutefois pas nécessairement inférieure à celle de la barrette de dilatation.

Grâce à ces dispositions, il est possible d'assurer une transition plus graduelle entre le bord de fuite et la plateforme, évitant les angles vifs pouvant être à l'origine de grains parasites. Comme la pièce brute résultant du procédé de fonderie utilisant un tel modèle doit en tout cas être ultérieurement usinée pour éliminer la barrette de dilatation, ce voile sera éliminé dans la même étape d'usinage sans engendrer d'opérations supplémentaires.

Avantageusement, le bord libre du voile peut s'étendre d'un bord de la plateforme à la barrette de dilatation, de manière à éviter la germination de grains parasites non seulement entre la plateforme et le bord de fuite, mais aussi sur le bord de la plateforme.

Afin de mieux éviter la formation de grains parasites, le modèle peut présenter une transition progressive entre un bord libre de la barrette de dilatation et le bord libre du voile. En outre, le voile peut être d'épaisseur moindre ou égale à une épaisseur de la barrette de dilatation, et le bord libre du voile être arrondi dans un plan transversal.

Le modèle peut aussi comprendre un segment hors-pièce en prolongation du corps sur une extrémité opposée au pied de pale, notamment afin de permettre une transition douce entre un canal sélecteur et le corps de la pale. Dans ce cas, le voile peut présenter une hauteur non supérieure à une moitié de la hauteur du corps avec le segment hors-pièce.

Afin aussi de limiter le nombre d'angles pouvant générer des grains parasites, une jonction entre le voile et la plateforme peut être en prolongation d'une jonction entre l'intrados et la plateforme.

Afin de faciliter la solidification dirigée, ce modèle pour fonderie peut comprendre aussi un modèle de canal sélecteur relié à une extrémité du corps de pale opposée au pied de pale. Dans un procédé de fonderie utilisant un moule formé autour de ce modèle pour fonderie, en refroidissant progressivement le métal en fusion dans le moule à partir d'une cavité starter reliée à la cavité en forme de pale par un canal sélecteur, par exemple en forme de chicane, il est possible d'assurer qu'un seul des grains ayant germiné dans la cavité starter se propage jusqu'à la cavité conformant la pale.

L'invention concerne également une grappe d'une pluralité de tels modèles pour fonderie, reliés par un arbre de manière à pouvoir assurer la production simultanée de plusieurs pales.

L'invention concerne également un procédé de fabrication d'un moule carapace, comprenant les étapes de trempage d'au moins un tel modèle de fonderie dans une barbotine, saupoudrage de l'au moins un modèle enduit de barbotine avec du sable réfractaire pour former une carapace autour de l'au moins un modèle, évacuation de l'au moins un modèle, et cuisson de la carapace. En outre, elle concerne aussi un procédé de fonderie dans lequel cette fabrication du moule carapace est suivie d'une coulée de métal en fusion dans le moule carapace, le refroidissement et solidification dirigée du métal, le décochage pour récupérer une pièce métallique brute, et la finition de la pièce brute. Cette étape de finition peut notamment comporter l'usinage d'éléments hors-pièce de la pièce brute.

### Brève description des dessins

L'invention sera bien comprise et ses avantages apparaîtront mieux, à la lecture de la description détaillée qui suit, d'un mode de réalisation représenté à titre d'exemple non limitatif. La description se réfère aux dessins annexés sur lesquels :
- la figure 1 illustre schématiquement la mise en oeuvre d'un procédé de fonderie à solidification dirigée ;
- la figure 2 illustre schématiquement une grappe de modèles de fonderie ;
- la figure 3 est une vue d'un côté d'un modèle de fonderie suivant un mode de réalisation ;
- la figure 4 est une vue d'un côté opposé du modèle de la figure 3 ;
- la figure 5 est une coupe transversale du modèle des figures 3 et 4 suivant la ligne V-V ;
- la figure 6 est une coupe transversale du modèle des figures 3 à 5 suivant la ligne VI-VI ; et
- la figure 7 est une coupe longitudinale, suivant la ligne VII-VII, d'une partie du modèle des figures 3 à 6.

### Description détaillée de l'invention

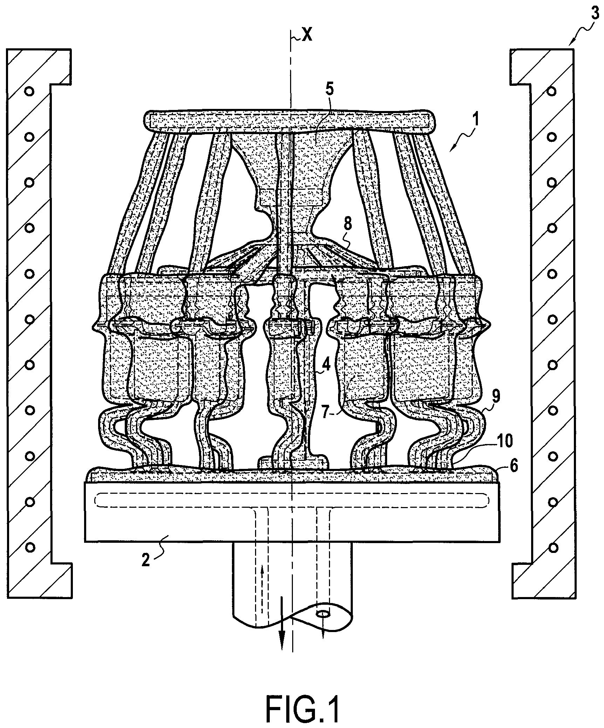

La figure 1 illustre comment un refroidissement progressif du métal en fusion destiné à obtenir une solidification dirigée peut typiquement être réalisé dans un procédé de fonderie.

Le moule carapace 1 utilisé dans ce procédé comporte un descendant central 4 s'étendant, en direction de l'axe principal X, entre un godet de coulée 5 et une base 6 en forme de plateau. Pendant l'extraction du moule carapace 1 de la chambre de chauffage 3, cette base 6 va être directement en contact avec une sole 2. Le moule carapace 1 comprend aussi une pluralité de cavités de moulage 7 arrangées en grappe autour du descendant central 4. Chaque cavité de moulage 7 est reliée au godet de coulée 5 par un canal d'amenée 8 à travers duquel le métal en fusion est introduit lors de sa coulée. Chaque cavité de moulage 7 est aussi également reliée par le bas, à travers un canal sélecteur 9 en chicane, à un starter 10 formé par une plus petite cavité adjacente à la base 6.

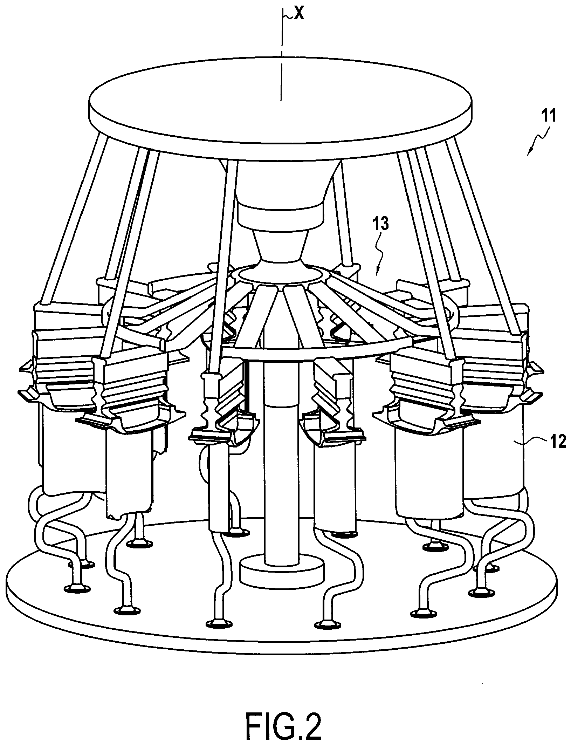

Le moule carapace 1 peut être produit par le procédé dit à cire perdue ou à modèle perdu. Une première étape d'un tel procédé est la création d'une grappe non permanente 11 comprenant une pluralité de modèles 12 reliés par un arbre 13, comme celle illustrée sur la figure 2. Tant les modèles 12 comme l'arbre 13, étant destinés à former des volumes creux dans le moule carapace 1, sont formés en une matière à basse température de fusion, comme une cire ou résine de modelage. Lorsque la production de grands nombres de pièces est envisagée, il est notamment possible de produire ces éléments par injection de la cire ou résine de modelage dans un moule permanent.

Dans ce mode de réalisation, pour produire le moule carapace 1 à partir de cette grappe non permanente 11, on procède à tremper la grappe 11 dans une barbotine, pour ensuite la saupoudrer avec un sable réfractaire. Ces étapes de trempage et saupoudrage peuvent être répétées plusieurs fois, jusqu'à former une carapace de sable imprégné de barbotine d'une épaisseur souhaitée autour de la grappe 11.

La grappe 11 enrobée de cette carapace peut ensuite être chauffée pour faire fondre et évacuer de l'intérieur de la carapace la matière à basse température de fusion de la grappe 11. Ensuite, dans une étape de cuisson à plus haute température, la barbotine se solidifie de manière à consolider le sable réfractaire pour former le moule carapace 1.

Le métal ou alliage métallique utilisé dans ce procédé de fonderie est coulé en fusion dans le moule carapace 1, à travers le godet de coulée 5, et remplit les cavités de moulage à travers les canaux d'amenée 8. Pendant cette coulée, le moule carapace 1 est maintenu dans une chambre de chauffage 3, comme illustré sur la figure 1. Ensuite, afin d'obtenir le refroidissement progressif du métal en fusion, ce moule carapace 1, soutenu par un support 2 refroidi et mobile, est extrait de la chambre de chauffage 3, suivant un axe principal X, vers le bas. Le moule carapace 1 étant refroidi à travers de sa base 6 par le support 2, la solidification du métal en fusion va se déclencher dans les starters 10 et se propager vers le haut suite à l'extraction progressive du moule carapace 1 de la chambre de chauffage 3 par le bas. L'étranglement formé par chaque sélecteur 9, ainsi que sa forme en chicane, vont toutefois assurer qu'un seul grain, parmi ceux ayant initialement germiné dans chaque starter 10, va pouvoir continuer à s'étendre vers la cavité de moulage 7 correspondante.

Parmi les alliages métalliques pouvant être utilisés dans ce procédé, on compte notamment les alliages monocristallins de nickel, tels que, notamment, les AM1 et AM3 de SNECMA, mais aussi d'autres comme les CMSX-2®, CMSX-4®, CMSX-6 ®, et CMSX-10 ® du C-M Group, les René® N5 et N6 de General Electric, les RR2000 et SRR99 de Rolls-Royce, et les PWA 1480, 1484 et 1487 de Pratt & Whitney, entre autres. Le tableau 1 illustre les compositions de ces alliages :

**Tableau 1 : Compositions d'alliages de nickel monocristallins en % massique**

| Alliage | Cr | Co | Mo | W | Al | Ti | Ta | Nb | Re | Hf | C | B | Ni |
|---|---|---|---|---|---|---|---|---|---|---|---|---|---|
| CMSX-2 | 8,0 | 5,0 | 0,6 | 8,0 | 5,6 | 1,0 | 6,0 | - | - | - | - | - | Bal |
| CMSX-4 | 6,5 | 9,6 | 0,6 | 6,4 | 5,6 | 1,0 | 6,5 | - | 3,0 | 0,1 | - | - | Bal |
| CMSX-6 | 10,0 | 5,0 | 3,0 | - | 4,8 | 4,7 | 6,0 | - | - | 0,1 | - | - | Bal |
| CMSX-10 | 2,0 | 3,0 | 0,4 | 5,0 | 5,7 | 0,2 | 8,0 | - | 6,0 | 0,03 | - | - | Bal |
| René N5 | 7,0 | 8,0 | 2,0 | 5,0 | 6,2 | - | 7,0 | - | 3,0 | 0,2 | - | - | Bal |
| René N6 | 4,2 | 12,5 | 1,4 | 6,0 | 5,75 | - | 7,2 | - | 5,4 | 0,15 | 0,05 | 0,004 | Bal |
| RR2000 | 10,0 | 15,0 | 3,0 | - | 5,5 | 4,0 | - | - | - | - | - | - | Bal |
| SRR99 | 8,0 | 5,0 | - | 10,0 | 5,5 | 2,2 | 12,0 | - | - | - | - | - | Bal |
| PWA1480 | 10,0 | 5,0 | - | 4,0 | 5,0 | 1,5 | 12,0 | - | - | - | 0,07 | - | Bal |
| PWA1484 | 5,0 | 10,0 | 2,0 | 6,0 | 5,6 | - | 9,0 | - | 3,0 | 0,1 | - | - | Bal |
| PWA1487 | 5,0 | 10,0 | 1,9 | 5,9 | 5,6 | - | 8,4 | - | 3,0 | 0,25 | - | - | Bal |
| AM1 | 7,0 | 8,0 | 2,0 | 5,0 | 5,0 | 1,8 | 8,0 | 1,0 | - | - | - | - | Bal |
| AM3 | 8,0 | 5,5 | 2,25 | 5,0 | 6,0 | 2,0 | 3,5 | - | - | - | - | - | Bal |

Après le refroidissement et la solidification du métal dans le moule carapace 1, celui-ci pourra être décoché pour libérer les pièces métalliques, lesquelles pourront ensuite être finies par des procédés d'usinage et/ou des traitements de surface.

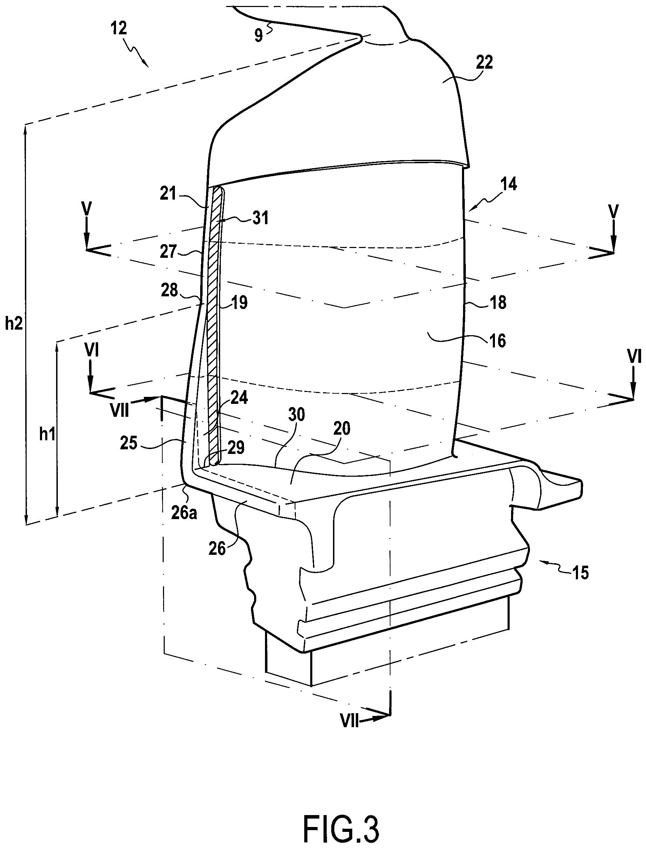

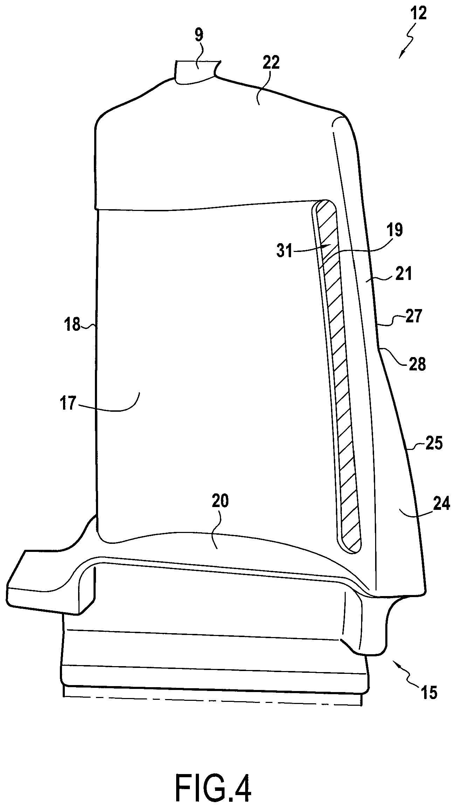

Lorsque les pièces à mouler présentent des formes complexes, celles-ci peuvent toutefois compliquer la solidification dirigée du métal dans chaque cavité de moulage 7. En particulier, les angles vifs dans la cavité 7 peuvent engendrer des grains parasites qui affaiblissent la pièce. Afin d'éviter la formation de ces grains parasites, les modèles 12 reçoivent, dans ce mode de réalisation, des éléments adjoints adoucissant certains angles vifs dans les cavités de moulage 7. Un tel modèle de fonderie 12 pour la production d'une pale de turbomachine est illustré sur les figures 3 et 4. Ce modèle de fonderie 12 présente ainsi une forme de pale de turbomachine avec un corps de pale 14 et un pied de pale 15 servant à assurer la fixation de la pale à un rotor de turbomachine. Le corps de pale 14 présente un extrados 16 et un intrados 17, se rejoignant au bord d'attaque 18 et au bord de fuite 19. Le corps de pale 14 et le pied de pale 15 sont séparés par une plateforme 20. Le modèle 12 comprend aussi des éléments hors-pièce, et notamment une barrette de dilatation 21 adjacente au bord de fuite 19 et un segment hors-pièce 22 en prolongation du corps de pale 14 sur une extrémité opposée au pied de pale 15. Ce segment hors-pièce 22 est destiné à être relié au canal sélecteur 9, et le pied de pale 15 est destiné à être relié au canal d'amenée 8, de telle manière que, dans la cavité de moulage 7 formée par le modèle 12 dans le moule carapace 1, le métal en fusion coule du pied de pale 15 vers le corps de pale 14 pendant la coulée, et se solidifie ensuite en direction opposée lors de sa solidification dirigée.

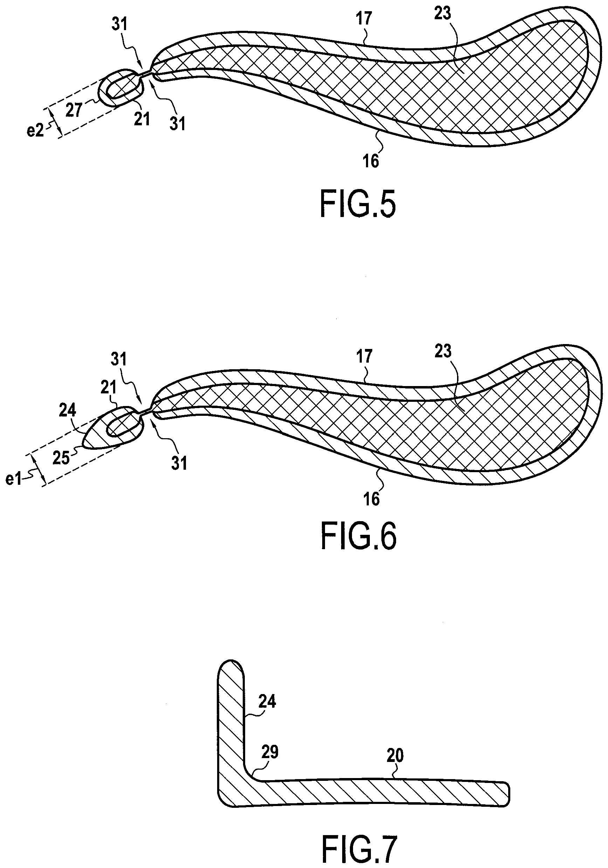

Le modèle 12 incorpore aussi un noyau solide réfractaire 23 afin de former une cavité dans la pale de turbomachine. De chaque côté du modèle 12, une surface vernie 31 de ce noyau 23 affleure à la surface du modèle 12 entre le bord de fuite 19 et la barrette 21, comme illustré sur les figures 5 et 6. Lors des étapes de trempage et saupoudrage du modèle 12, la carapace de sable imprégné de barbotine va se former sur les surfaces exposées du modèle 12, y compris sur ces surfaces vernies 31 du noyau 23. Lors de l'évacuation et/ou la cuisson de la carapace, le vernis recouvrant ces surfaces 31 va également être éliminé, créant ainsi un faible jeu, typiquement entre 2 et 3 centièmes de millimètre, entre ces surfaces 31 du noyau et des surfaces internes correspondantes du moule carapace 1. A cet endroit, ce faible jeu permet un déplacement du noyau 23, perpendiculairement à son épaisseur, par rapport au moule carapace 1, guidant ainsi la dilatation thermique du noyau 23 pendant la coulée et le refroidissement du métal. La faiblesse de ce jeu évite toutefois que le métal fondu se faufile entre le noyau 23 et le moule carapace 1 à cet endroit. Ainsi, dans la pièce brute, le bord de fuite et la barrette seront séparés par un écart qui facilitera ensuite l'usinage de la barrette lors de la finition de la pièce brute.

Un endroit particulièrement critique pour la formation de grains parasites est la proximité de l'intersection du bord de fuite 19 et la plateforme 20. A cet endroit peuvent se rejoindre plusieurs angles vifs, ce qui accroît le danger de formation de grains parasites. Afin d'éviter cela, dans le mode de réalisation illustré, le modèle 12 présente aussi un voile fin 24 entre la barrette 21 et la plateforme 20. Ce voile 24 présente un bord libre 25 s'étendant entre la barrette 21 et une extrémité 26a d'un bord 26 de la plateforme 20. L'épaisseur e1 du voile 24 est égale ou inférieure à l'épaisseur e2 de la barrette 21 adjacente. La hauteur h1 du voile 24 est approximativement la moitié de la hauteur brute h2 du corps de pale 14 avec le segment hors-pièce 22. Tant le bord libre 25 du voile 24 comme le bord extérieur 27 de la barrette 21 sont arrondis, comme illustré sur les figures 5 et 6 et la transition 28 entre les deux est très progressive. La barrette 21 et le voile 24 suivent tous les deux l'éventuelle courbure du bord de fuite 19. La transition 29 entre le voile 24 et la plateforme 20 présente un arrondi dans le plan longitudinal comme illustré sur la figure 7, et est en prolongation de la ligne de transition 30 entre l'extrados 17 et la plateforme 20.

Dans le procédé de fonderie servant à produire au moins une pale de turbomachine à partir d'un tel modèle, le voile et la barrette dans la pièce brute de moulage pourront être facilement éliminés par usinage de manière simultané lors de la finition de cette pièce brute de moulage. On peut ainsi obtenir une pièce nette sans devoir effectuer plus d'opérations d'usinage qu'avec un modèle qui serait dépourvu du voile 24.

Quoique la présente invention ait été décrite en se référant à un exemple de réalisation spécifique, il est évident que des différentes modifications et changements peuvent être effectués sur ces exemples sans sortir de la portée générale de l'invention telle que définie par les revendications. En outre, des caractéristiques individuelles des différents modes de réalisation évoqués peuvent être combinées dans des modes de réalisation additionnels. Par conséquent, la description et les dessins doivent être considérés dans un sens illustratif plutôt que restrictif.

## Revendications

1. Modèle (12) pour fonderie à modèle perdu, en forme de pale de turbomachine avec un pied (15) et un corps (14) séparés par une plateforme (20) sensiblement perpendiculaire à un axe principal de la pale, ledit corps (14) de la pale présentant un intrados (17), un extrados (16), un bord d'attaque (18) et un bord de fuite (19), le modèle (12) comprenant en outre une barrette de dilatation (21) adjacente au bord de fuite (19), et un noyau réfractaire (23), noyé dans le modèle (12) mais présentant, tant du côté de l'intrados (17) que de celui de l'extrados (16), une surface vernie (31) affleurant entre le bord de fuite (19) et la barrette de dilatation (21), le modèle (12) étant **caractérisé en ce qu'**il comprend aussi un voile (24) s'étendant entre la plateforme (20) et ladite barrette de dilatation (21) et présentant un bord libre (25) entre les deux.

2. Modèle (12) suivant la revendication 1, dans lequel le bord libre (25) du voile (24) s'étend d'un bord (26) de la plateforme (20) à la barrette de dilatation (21).

3. Modèle (12) suivant l'une quelconque des revendications précédentes, présentant une transition (28) progressive entre un bord libre (27) de la barrette de dilatation (21) et le bord libre (25) du voile (24).

4. Modèle (12) suivant l'une quelconque des revendications précédentes, dans lequel le voile (24) est d'épaisseur moindre ou égale à une épaisseur de la barrette de dilatation (21).

5. Modèle (12) suivant l'une quelconque des revendications précédentes, dans lequel le bord libre (25) du voile (24) est arrondi dans un plan transversal.

6. Modèle (12) suivant l'une quelconque des revendications précédentes, comprenant aussi un segment hors-pièce (22) en prolongation du corps (14) sur une extrémité opposée au pied (15) de pale, et dans lequel le voile (24) présente une hauteur non supérieure à une moitié de la hauteur du corps (14) avec le segment hors-pièce (22).

7. Modèle (12) suivant l'une quelconque des revendications précédentes, dans lequel une jonction (29) entre le voile (24) et la plateforme (20) est en prolongation d'une jonction (30) entre l'extrados (16) et la plateforme (20).

8. Modèle (12) suivant l'une quelconque des revendications précédentes, avec un modèle de canal sélecteur (9) relié à une extrémité du corps (14) de pale opposée au pied (15) de pale.

9. Grappe (11) comprenant une pluralité de modèles (12) suivant les revendications précédentes, reliés par un arbre (13).

10. Procédé de fabrication d'un moule carapace (1), comprenant les étapes suivantes :
trempage d'au moins un modèle de fonderie (12) suivant l'une quelconque des revendications 1 à 8 dans une barbotine ;
saupoudrage de l'au moins un modèle (12) enduit de barbotine avec du sable réfractaire pour former une carapace autour de l'au moins un modèle (12) ;
évacuation de l'au moins un modèle (12) ; et
cuisson de la carapace.

11. Procédé de fonderie comprenant au moins les étapes suivantes :
fabrication d'un moule carapace (1) suivant la revendication 10 ;
coulée de métal en fusion dans le moule carapace (1) ;
refroidissement et solidification dirigée du métal ;
décochage du moule carapace (1) pour récupérer une pièce métallique brute ; et
finition de la pièce brute.

## Patentansprüche

1. Modell (12) für das Gießen mit verlorenem Modell in Form eines Turbomaschinenblatts mit einem Fuß (15) und einem Körper (14), die durch eine Plattform (20) getrennt sind, die im Wesentlichen senkrecht zu einer Hauptachse des Blatts verläuft, wobei der Blattkörper (14) eine Wölbungsinnenseite (Intrados) (17), eine Wölbungsaußenseite (Extrados) (16), eine Anströmkante (18) und eine Abströmkante (19) aufweist, wobei das Modell (12) ferner eine an die Abströmkante (19) angrenzende Dehnungsleiste (21) und einen feuerfesten Kern (23) umfasst, der in das Modell (12) eingebettet ist aber sowohl auf der Wölbungsinnenseite (17) als auch auf der Wölbungsaußenseite (16) eine lackierte Oberfläche (31) aufweist, die zwischen der Abströmkante (19) und der Dehnungsleiste (21) bündig herausschaut, wobei das Modell (12) **dadurch gekennzeichnet ist, dass** es auch einen Steg (24) umfasst, der sich zwischen der Plattform (20) und der Dehnungsleiste (21) erstreckt und eine freie Kante (25) zwischen diesen beiden aufweist.

2. Modell (12) nach Anspruch 1, wobei sich die freie Kante (25) des Stegs (24) von einer Kante (26) der Plattform (20) bis zur Dehnungsleiste (21) erstreckt.

3. Modell (12) nach einem der obigen Ansprüche, das einen progressiven Übergang (28) zwischen einer freien Kante (27) der Dehnungsleiste (21) und der freien Kante (25) des Stegs (24) aufweist.

4. Modell (12) nach einem der obigen Ansprüche, wobei der Steg (24) eine Dicke aufweist, die kleiner oder gleich einer Dicke der Dehnungsleiste (21) ist.

5. Modell (12) nach einem der obigen Ansprüche, bei dem die freie Kante (25) des Stegs (24) in einer Querebene abgerundet ist.

6. Modell (12) nach einem der obigen Ansprüche, auch umfassend ein Off-Piece-Segment (22) in Verlängerung des Körpers (14) an einem dem Blattfuß (15) gegenüberliegenden Ende, wobei der Steg (24) eine Höhe von nicht mehr als der halben Höhe des Körpers (14) mit dem Off-Piece-Segment (22) aufweist.

7. Modell (12) nach einem der obigen Ansprüche, bei dem eine Verbindungsstelle (29) zwischen dem Steg (24) und der Plattform (20) eine Verlängerung einer Verbindungsstelle (30) zwischen der Wölbungsaußenseite (16) und der Plattform (20) darstellt.

8. Modell (12) nach einem der obigen Ansprüche, mit einem Wahlkanalmodell (9), das mit einem Ende des Blattkörpers (14) gegenüber dem Blattfuß (15) verbunden ist.

9. Gruppe (11), umfassend eine Vielzahl von Modellen (12) nach den obigen Ansprüchen, die durch einen Schaft (13) verbunden sind.

10. Verfahren zur Herstellung einer Maskengießform (1), umfassend die folgenden Schritte:
Eintauchen mindestens eines Gusskörpermodells (12) nach einem der Ansprüche 1 bis 8 in eine Gießmasse,
Bestreuen des mindestens einen mit Gießmasse beschichteten Modells (12) mit feuerfestem Sand, um eine Maskenform um das mindestens eine Modell (12) herum zu bilden,
Entfernen des mindestens einen Modells (12) und
Aushärten der Maskenform.

11. Gießverfahren, umfassend mindestens die folgenden Schritte:
Herstellen einer Maskengießform (1) nach Anspruch 10,
Gießen von geschmolzenem Metall in die Maskengießform (1),
Abkühlen und gezieltes Verfestigen des Metalls,
Entfernen der Maskengießform (1), um ein Rohmetallteil zu gewinnen, und
Fertigstellen des Rohteils.

## Claims

1. A pattern (12) for lost-pattern casting, the pattern being in the shape of a turbomachine blade with a root (15) and a body (14) on either side of a platform (20) that is substantially perpendicular to a main axis of the blade, said blade body (14) presenting a pressure side (17), a suction side (16), a leading edge (18), and a trailing edge (19), the pattern (12) also including an expansion strip (21) adjacent to the trailing edge (19), and a refractory core (23) embedded in the pattern (12) but presenting, both on the pressure side (17) and on the suction side (16), a respective flush varnished surface (31) between the trailing edge (19) and the expansion strip (21), the pattern (12) being **characterized in that** it also includes a web (24) extending between the platform (20) and said expansion strip (21) and presenting a free edge (25) between them.

2. A pattern (12) according to claim 1, wherein the free edge (25) of the web (24) extends from one edge (26) of the platform (20) to the expansion strip (21).

3. A pattern (12) according to claim 1, presenting a progressive transition (28) between a free edge (27) of the expansion strip (21) and the free edge (25) of the web (24).

4. A pattern (12) according to claim 1, wherein the web (24) is of thickness that is less than or equal to a thickness of the expansion strip (21).

5. A pattern (12) according to claim 1, wherein the free edge (25) of the web (24) is rounded in a transverse plane.

6. A pattern (12) according to claim 1, also including an out-of-part segment (22) extending from the body (14) at an end opposite from the root (15) of the blade, and wherein the web (24) presents a height that is not greater than half the height of the body (14) and the out-of-part segment (22)together.

7. A pattern (12) according to claim 1, wherein a junction (29) between the web (24) and the platform (20) extends from a junction (30) between the suction side (16) and the platform (20).

8. A pattern (12) according to claim 1, with a selector channel pattern (9) that is connected to an end of the blade body (14) that is opposite from the blade root (15) .

9. An assembly (11) comprising a plurality of patterns (12) according to any one of the preceding claims that are connected together by a tree (13).

10. A method of fabricating a shell mold (1), the method comprising the following steps:
dipping at least one casting pattern (12) according to any one of claims 1 to 8 in a slip
powdering the at least one slip-coated pattern (12) with refractory sand in order to form a shell around at least one pattern (12);
removing the at least one pattern (12); and
baking the shell.

11. A casting method comprising at least the following steps:
fabricating a shell mold (1) in accordance with claim 10;
casting molten metal into the shell mold (1);
cooling the metal with directional solidification thereof;
knocking out the shell mold (1) in order to recover the raw metal casting; and
finishing the raw casting.
